(19) Europäisches Patentamt / European Patent Office / Office européen des brevets

(11) **EP 2 834 658 B1**

(12) **FASCICULE DE BREVET EUROPEEN**

(45) Date de publication et mention de la délivrance du brevet:
**07.09.2016 Bulletin 2016/36**

(21) Numéro de dépôt: **13713864.0**

(22) Date de dépôt: **29.03.2013**

(51) Int Cl.:
*G01R 33/00* *(2006.01)*  *G01R 33/09* *(2006.01)*

(86) Numéro de dépôt international:
**PCT/EP2013/056820**

(87) Numéro de publication internationale:
**WO 2013/149967 (10.10.2013 Gazette 2013/41)**

(54) **PROCEDE ET DISPOSITIF DE MESURE D'UN CHAMP MAGNETIQUE ET DE LA TEMPERATURE D'UN TRANSDUCTEUR MAGNETO-RESISTIF**

VERFAHREN UND VORRICHTUNG ZUM MESSEN EINES MAGNETFELDES UND DER TEMPERATUR EINES MAGNETORESISTIVEN WANDLERS

METHOD AND DEVICE FOR MEASURING A MAGNETIC FIELD AND THE TEMPERATURE OF A MAGNETO-RESISTIVE TRANSDUCER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.04.2012 FR 1253207**

(43) Date de publication de la demande:
**11.02.2015 Bulletin 2015/07**

(73) Titulaires:
- **Commissariat à l'Énergie Atomique et aux Énergies Alternatives**
  **75015 Paris (FR)**
- **Renault S.A.S.**
  **92100 Boulogne-Billancourt (FR)**

(72) Inventeurs:
- **BACQUET, Sylvain**
  **F-38470 Chasselay (FR)**
- **AUZAS, Frédéric**
  **F-75014 Paris (FR)**
- **DELAET, Bertrand**
  **F-38190 Bernin (FR)**

(74) Mandataire: **GIE Innovation Competence Group**
**310, avenue Berthelot**
**69372 Lyon Cedex 08 (FR)**

(56) Documents cités:
**US-A1- 2005 077 890     US-A1- 2010 231 213**

- **HAN ET AL: "A Novel Zero-Drift Detection Method for Highly Sensitive GMR Biochips", IEEE TRANSACTIONS ON MAGNETICS, IEEE SERVICE CENTER, NEW YORK, NY, US, vol. 42, no. 10, 1 octobre 2006 (2006-10-01), pages 3560-3562, XP011149255, ISSN: 0018-9464, DOI: 10.1109/TMAG.2006.879615**

EP 2 834 658 B1

## Description

L'invention concerne un procédé et un dispositif de mesure d'un premier champ magnétique et de la température d'un transducteur magnéto-résistif, l'intensité du premier champ magnétique étant inconnue. L'invention a également pour objet un capteur de courant incorporant ce dispositif de mesure et un support d'enregistrement d'informations pour la mise en oeuvre du procédé ci-dessus.

Des procédés connus de mesure d'un premier champ magnétique et de la température d'un transducteur magnéto-résistif comporte :

- la production, par le transducteur magnéto-résistif, d'un signal de mesure fonction de l'intensité du premier champ magnétique, ce signal de mesure étant également fonction de la température du transducteur magnéto-résistif,
- l'établissement d'une mesure de l'intensité du premier champ magnétique à partir du signal de mesure produit, et
- l'établissement d'une mesure de la température du transducteur magnéto-résistif.

La mesure de la température du transducteur magnéto-résistif est par exemple utile pour compenser en température la mesure du premier champ magnétique ou la mesure du courant qui génère ce premier champ magnétique. Il a été proposé dans la demande US 2005/0077890 d'utiliser le même transducteur magnéto-résistif pour mesurer à la fois le premier champ magnétique et la température. Dans ce document, le premier champ magnétique est généré par un courant $I_m$ à mesurer circulant dans un conducteur électrique placé à proximité du transducteur magnéto-résistif. Lorsque la température du transducteur magnéto-résistif doit être mesurée, le courant $I_m$ est interrompu puis remplacé par un courant $I_c$ dont les caractéristiques sont connues. Le signal de mesure généré par le transducteur magnéto-résistif varie, pour un courant $I_c$ donné, en fonction de la température. Ainsi, en fixant le courant $I_c$, il est possible de mesurer la température à l'aide de ce transducteur magnéto-résistif.

Ce procédé est particulièrement avantageux puisque le même transducteur magnéto-résistif est utilisé pour mesurer la température et le premier champ magnétique.

Toutefois, la mesure de la température suppose d'interrompre le courant $I_m$. Or, lorsque le capteur de courant décrit dans US 2005/0077890 est utilisé, par exemple, pour mesurer le courant dans une phase d'un moteur électrique, il n'est pas possible d'interrompre le courant $I_m$.

De l'état de la technique est également connu de :

- US2010/231213A1, et

- HAN et Al : « Novel zero-drift détection method for highly sensitive GMR biochips », IEEE Transactions on magnetics, IEEE Service center, New York, US, vol. 42, N°10, 1 octobre 2006.

L'invention vise donc à proposer un procédé de mesure du premier champ magnétique et de la température du transducteur magnéto-résistif dans lequel il n'est pas nécessaire d'interrompre le premier champ magnétique pour réaliser la mesure de la température. Elle a donc pour objet un procédé conforme à la revendication 1.

Le procédé ci-dessus permet de mesurer la température du transducteur magnéto-résistif même en présence du premier champ magnétique inconnu. Il n'est donc pas nécessaire d'interrompre ce premier champ magnétique ou de connaître ses caractéristiques pour réaliser la mesure de la température.

Les modes de réalisation de ce procédé peuvent comporter une ou plusieurs des caractéristiques des revendications dépendantes.

Les modes de réalisation du procédé ci-dessus présentent en outre les avantages suivants :

- compenser la mesure de l'intensité d'une grandeur physique dépendante de la température en fonction de la température mesurée à l'aide du transducteur magnéto-résistif permet d'accroître la précision de la mesure de cette grandeur physique ;
- utiliser la température mesurée au même instant que le premier champ magnétique permet d'accroître la précision et la robustesse de la mesure du premier champ magnétique.

L'invention a également pour objet un support d'enregistrement d'informations comportant des instructions pour l'exécution du procédé ci-dessus de mesure, lorsque ces instructions sont exécutées par un calculateur électronique.

L'invention a également pour objet un dispositif de mesure d'un premier champ magnétique et de la température d'un transducteur magnéto-résistif conforme à la revendication 5.

Les modes de réalisation de ce dispositif de mesure peuvent comporter une ou plusieurs des caractéristiques des revendications dépendantes.

L'invention a également pour objet un capteur de courant conforme à la revendication 9.

Les modes de réalisation de ce capteur de courant peuvent comporter une ou plusieurs des caractéristiques des revendications dépendantes.

Ces modes de réalisation du capteur de courant présentent en outre les avantages suivants :

- utiliser une ligne conductrice indépendante du conducteur électrique permet d'optimiser la section du conducteur électrique indépendamment de la section transversale de la ligne conductrice et donc, par exemple, de mesurer des courants de forte intensité, c'est-à-dire dont l'intensité est supérieure à 10 ampères ou 100 ampères ;

- utiliser une même ligne de courant pour former à la fois le conducteur électrique et la ligne conductrice permet de simplifier la réalisation du capteur de courant.

L'invention sera mieux comprise à la lecture de la description qui va suivre, donnée uniquement à titre d'exemple non limitatif et faite en se référant aux dessins sur lesquels :

- la figure 1 est une illustration schématique d'un capteur de courant,
- la figure 2 est une illustration schématique en coupe verticale de la section transversale d'un barreau magnéto-résistif utilisé dans le capteur de la figure 1 ;
- la figure 3 est un graphe illustrant la variation de résistance du barreau magnéto-résistif de la figure 2 en réponse à une variation de l'intensité d'un champ magnétique ;
- la figure 4 est un graphe illustrant la variation d'un signal de mesure du capteur de la figure 1 en fonction de la température pour différents champs magnétiques constants,
- la figure 5 est un graphe illustrant la variation du signal de mesure du capteur de la figure 1 en réponse à une variation de l'intensité du courant circulant dans une ligne de courant pour différentes températures;
- la figure 6 est un organigramme d'un procédé de mesure d'un courant à l'aide du capteur de la figure 1 ; et
- la figure 7 est une illustration schématique d'un autre mode de réalisation du capteur de courant de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

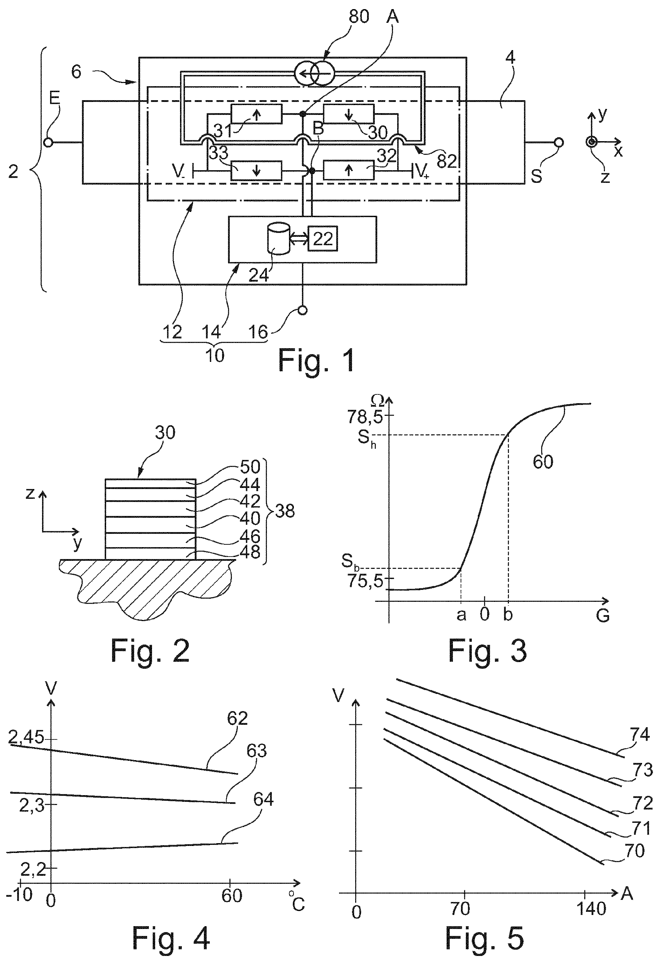

La figure 1 représente un capteur 2 de courant. Le courant mesuré peut être un courant continu ou alternatif. Dans le cas d'un courant alternatif, sa fréquence sera typiquement inférieure à 100 MHz, 0,1 GHz ou 0,5GHz. Ce capteur 2 comporte un conducteur électrique 4. Le conducteur 4 est rectiligne et parallèle à une direction horizontale X d'un repère orthogonal X, Y, Z. Dans le repère X, Y, Z, la direction Y est également horizontale et la direction Z est verticale. Les extrémités opposées du conducteur 4 sont raccordées, respectivement, à des bornes E et S d'entrée et de sortie du courant $I_m$ à mesurer.

Un support 6 électriquement isolant est fixé, sans aucun degré de liberté, sur le conducteur 4. Par la suite, on considère qu'un matériau est isolant si sa résistivité est supérieure à 1 $\Omega$.m et, de préférence, supérieure à $10^4$ $\Omega$.m à 25°C.

Le capteur 2 comporte également un dispositif 10 de mesure de champ magnétique fixé sans aucun degré de liberté sur ce support 6. Ce dispositif 10 mesure notamment un champ magnétique $H_m$ généré par le courant $I_m$ circulant dans le conducteur 4. Le champ $H_m$ est perpendiculaire à la direction X. A cet effet, le dispositif 10 comprend :

- un transducteur magnéto-résistif 12 qui transforme le champ magnétique dans lequel il est plongé en un signal électrique V de mesure, et
- une unité électronique 14 de traitement du signal de mesure.

Ici, le signal V est une tension. Le signal V suit l'évolution temporelle du champ mesuré. Ainsi, lorsque le champ mesuré est alternatif, le signal V est une tension alternative de même fréquence. A chaque instant, l'amplitude du signal V est représentative de l'amplitude du champ mesuré. Cette unité 14 est apte à établir la mesure de l'intensité du champ $H_m$ le long de la direction de mesure Y à partir du signal V généré par le transducteur 12. Cette unité 14 est également apte à établir l'intensité du courant $I_m$ à partir de l'intensité mesurée du champ $H_m$. L'unité 14 restitue l'intensité établie du courant $I_m$ sur une sortie 16.

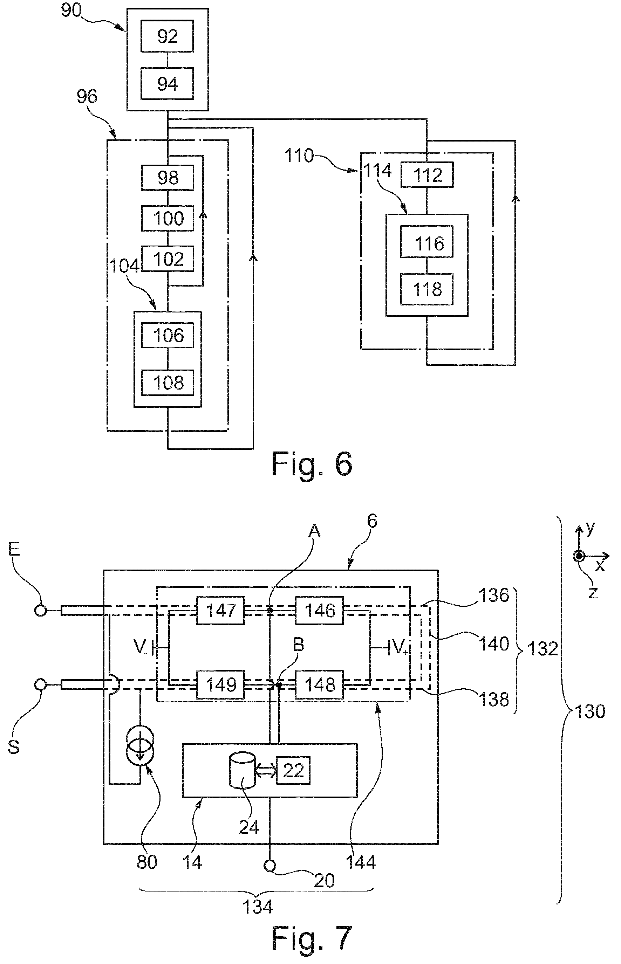

Par exemple, l'unité 14 est réalisée à partir d'un calculateur électronique 22 programmable apte à exécuter des instructions enregistrées sur un support d'enregistrement d'informations. A cet effet, l'unité 14 comprend une mémoire 24 raccordée au calculateur 22. Cette mémoire 24 stocke les instructions nécessaires pour exécuter le procédé de la figure 6.

Le transducteur 12 comporte quatre barreaux magnéto-résistifs 30 à 33 électriquement raccordés entre eux pour former un pont de Wheatstone. Un barreau magnéto-résistif est un composant dont la résistivité varie en fonction du champ magnétique dans lequel il est placé. Les barreaux magnéto-résistifs dont il s'agit ici sont des vannes de spin.

Ce pont de Wheatstone comprend une première et une seconde branches électriquement raccordées en parallèle entre des potentiels de référence V+ et V-. Le potentiel V- est par exemple la masse ou la terre. La première branche comprend successivement, en allant du potentiel V+ vers le potentiel V-, les barreaux magnéto-résistifs 30 et 31 raccordés en série par l'intermédiaire d'un point milieu A. La seconde branche comprend successivement, en allant du potentiel V+ vers le potentiel V-, les barreaux 32 et 33 raccordés en série par l'intermédiaire d'un point milieu B.

Les potentiels VA et $V_B$ au niveau des points milieux A et B sont donnés par les relations suivantes :

$$V_A = (V_+ - V_-)R_2/(R_1+R_2)$$

$$V_B = (V_+ - V_-)R_4/(R_3+R_4)$$

ou $R_1$, $R_2$, $R_3$ et $R_4$ désignent les résistances, respectivement, des barreaux 30 à 33.

Ici, chaque barreau 30 à 33 a essentiellement une forme de parallélépipède rectangle dont au moins deux grandes faces s'étendent horizontalement. La direction dans laquelle s'étend principalement le barreau est appelée direction longitudinale. Ici, cette direction est horizontale et parallèle à la direction X. La direction transversale est parallèle à la direction Y.

De préférence, chaque barreau présente un rapport de forme important, c'est-à-dire un rapport de forme supérieur à vingt et, de préférence, supérieur à quarante ou cent. Ce rapport de forme est défini par le rapport entre la longueur L du barreau sur sa largeur transversale W.

Par exemple, la longueur L est supérieure à 50 ou 100 $\mu$m et, de préférence, inférieure à 1 mm. La largeur transversale W est typiquement supérieure à 0,3 $\mu$m ou 1 $\mu$m et, de préférence, inférieure à 15 $\mu$m ou 30 $\mu$m.

Ici, les barreaux 30 à 33 sont tous disposés au-dessus du conducteur 4.

Les barreaux 31 et 32 sont agencés de sorte que leurs résistances respectives varient dans le même sens en réponse à la même variation du courant $I_m$ à mesurer. Ici, les barreaux 31 et 32 sont identiques.

Dans ce mode de réalisation, les barreaux 30 et 33 sont identiques aux barreaux 31 et 32 sauf que la direction d'aimantation de leurs couches de référence respectives est opposée à celles des barreaux 31 et 32. Sur la figure 1, la direction d'aimantation de chaque barreau est représentée par une flèche. La résistance des barreaux 31 et 32 varie donc en sens opposé à celle des barreaux 30 et 33.

L'unité 14 de traitement reçoit la différence entre les potentiels VA et $V_B$ pour établir l'intensité du courant $I_m$ circulant dans le conducteur 4. Cette différence entre les potentiels VA et $V_B$ constitue le signal V de mesure.

Les structures des différents barreaux magnéto-résistifs sont identiques et seule la structure du barreau 30 est décrite plus en détail en références à la figure 2.

Le barreau 30 comporte un empilement 38, immédiatement consécutif, d'une couche de référence 40, d'un espaceur 42 et d'une couche libre 44 dans la direction verticale. Un tel empilement pour obtenir une magnétorésistance géante ou GMR (Geant Magneto-Resistance) est conventionnel. Les GMR sont également connues sous le terme « vannes de spin ». Cet empilement ne sera donc pas décrit en détail.

La couche 40 de référence a une aimantation de direction fixe et perpendiculaire à la direction X. Par « direction fixe », on désigne ici le fait que la direction d'aimantation de cette couche est beaucoup plus difficile à modifier que la direction d'aimantation de la couche libre.

Par exemple, la couche 40 est une couche ferromagnétique. Elle peut être réalisée en cobalt, en nickel ou en fer ou dans leurs alliages tels que CoFe, NiFe, CoFeB ou autres.

La direction d'aimantation de la couche 40 est fixée à l'aide d'une couche 46 anti-ferromagnétique. La couche 46 sert à piéger la direction d'aimantation de la couche 40. Par exemple, la couche 46 est réalisée dans un alliage de manganèse tel que l'un des alliages suivants IrMn, PtMn, FeMn, NiMn ou autres.

L'espaceur 42 est une couche réalisée en matériau non magnétique. Cet espaceur 42 est suffisamment épais pour découpler magnétiquement les couches 40 et 44. Ici, l'espaceur 42 est une couche en matériau conducteur tel que du cuivre.

La couche libre 44 présente une direction d'aimantation qui peut plus facilement tourner que celle de la couche de référence. La direction de plus facile aimantation de cette couche 44 est ici parallèle à la direction longitudinale du barreau, c'est-à-dire ici la direction X. Par exemple, la couche 44 est une couche réalisée en matériau ferromagnétique ou un empilement de couches ferromagnétiques.

L'empilement 38 comprend à chaque extrémité une électrode conductrice, respectivement, 48 et 50 pour faire circuler le courant qui traverse le barreau magnétorésistif perpendiculairement au plan des couches 40, 42 et 44.

Pour simplifier la figure 2, les rapports d'épaisseurs entre les différentes couches de l'empilement 38 n'ont pas été respectés sur cette figure.

La variation de la résistance du barreau magnéto-résistif 30 en fonction de l'intensité d'un champ magnétique à l'intérieur duquel il est placé est représentée sur la figure 3 par une courbe 60. L'axe des abscisses est gradué en Gauss et l'axe des ordonnées représente la résistance du barreau 30 exprimée en Ohm.

Sur cette figure, la courbe 60 varie linéairement à plus ou moins $x_i$% près dans une plage [a; b] située autour du champ nul. Ici, la valeur $x_i$ est choisie inférieure à 20 % ou 10 % et, de préférence, inférieure à 5 % ou 1 % ou 0,5 %. Par exemple, dans ce mode de réalisation, la valeur $x_i$ est choisie égale à 1% ou 0,25 %. Dans ces conditions, les bornes a et b sont sensiblement égales, respectivement, à -20G et +30G.

Sur la plage [a; b], la résistance du barreau 30 varie linéairement entre un seuil bas $S_b$ et un seuil haut $S_h$. Les valeurs des bornes a, b et des seuils $S_h$ et $S_b$ sont connues. Par exemple, elles sont mesurées expérimentalement. En dehors de la plage [a; b], la réponse du barreau 30 varie de façon non linéaire. Par « non linéaire », on signifie que si la valeur de la borne « a » était diminuée ou si la valeur de la borne « b » était augmentée, alors la réponse du barreau 30 ne serait plus linéaire à $\pm x_i$% près sur cette nouvelle plage [a ; b].

Puisque la réponse du barreau 30 est linéaire dans la plage [a ; b], la réponse du transducteur magnéto-résistif 12 varie également linéairement à $\pm x_i$% près dans la plage [a; b].

Par la suite, on se place dans le cas où le transducteur magnéto-résistif 12 travaille dans la plage [a ; b].

La résistance de chaque barreau magnéto-résistif 30 à 33 varie également en fonction de la température de ce barreau. Ainsi, le signal V généré par le transducteur 12 varie aussi en fonction de la température des barreaux magnéto-résistifs.

Ici, le transducteur magnéto-résistif 12 est tel que, quand il est plongé dans un champ magnétique constant quelconque compris dans la plage [a, b], le signal de mesure qu'il génère varie linéairement en fonction de la température sur une grande plage de températures, c'est-à-dire sur une plage de plus de 40°C ou 70°C de large. Par exemple, le rapport de forme du transducteur magnéto-résistif 12 est déterminé expérimentalement pour que sur la plage [a, b], le signal de mesure varie linéairement à la fois en fonction du champ magnétique à mesurer mais aussi en fonction de la température. La linéarité de la variation de température sur la plage de plus de 40°C est par exemple inférieure à 20 ou 10 ou 5 ou 1 % selon l'application envisagée.

La figure 4 représente l'évolution du signal V du transducteur 12 en fonction de la température pour différentes intensités constantes du courant $I_m$ et en présence du seul champ magnétique terrestre. Sur ce graphe, les courbes 62 à 64 ont été obtenues pour des valeurs du courant $I_m$ égales, respectivement, à 0 A, 70 A et 120 A. On peut remarquer que la pente des courbes des droites 62 à 64 varie en fonction de l'intensité du champ magnétique constant dans laquelle est plongé le transducteur 12.

La figure 5 représente l'évolution du signal V généré par le transducteur 12 en fonction de l'intensité du courant $I_m$ pour différentes températures. Sur ce graphe, les droites 70 à 74 ont été obtenues pour des températures égales à, respectivement, 0°C, 20°C, 40°C, 80°C et 120°C.

Comme pour le graphe de la figure 4, on peut remarquer que la pente des droites 70 à 74 varie en fonction de la température.

Pour pouvoir mesurer la température du transducteur 12, le dispositif 10 est également équipé d'un générateur d'un second champ magnétique $H_c$. Dans ce mode de réalisation, ce générateur comporte:

- une source de courant 80 commandable, et
- une ligne conductrice 82 dont les extrémités sont électriquement raccordées à la source de courant 80.

Ce générateur est électriquement isolé et distinct du transducteur magnéto-résistif. La source de courant 80 génère un courant $I_c$ qui circule dans la ligne 82. Les caractéristiques du courant $I_c$ sont connues. Ces caractéristiques sont les caractéristiques qui permettent de déterminer sans ambiguïté la forme d'onde du courant $I_c$. Par exemple, dans ce mode de réalisation, le courant $I_c$ est un courant alternatif sinusoïdal de fréquence $f_c$ et d'amplitude $A_c$ où, $f_c$ et $A_c$ sont connus à chaque instant et commandées par la source de courant 80.

La source du courant 80 est raccordée à l'unité de traitement 14. La liaison qui raccorde ces deux éléments n'a pas été représentée pour simplifier la figure 1. Cette liaison permet à l'unité 14 de connaître exactement les caractéristiques du courant $I_c$ circulant actuellement dans la ligne 82.

La ligne 82 s'étend parallèlement au conducteur 4 pour générer le champ magnétique $H_c$ parallèlement au champ magnétique $H_m$ à mesurer.

La ligne 82 est positionnée vis-à-vis des barreaux magnéto-résistifs 30 à 33 de telle manière que le champ $H_c$ dans lequel est plongé chaque barreau magnéto-résistif 30 à 33 est identique. Par exemple, la ligne 82 passe à mi-distance entre les barreaux 30 et 32 et entre les barreaux 31 et 33.

Le champ magnétique, noté $H_r$, dans lequel les barreaux magnéto-résistifs sont plongés, résulte de la combinaison des champs magnétiques $H_m$ et $H_c$. Ainsi, en fonctionnement, le signal de mesure V est essentiellement la somme de deux composantes $V_c$ et $V_m$. Les composantes $V_c$ et $V_m$ correspondent aux tensions correspondant seulement, respectivement, aux courants $I_c$ et $I_m$.

L'unité 14 de traitement est programmée pour mesurer aussi bien la température $T_m$ de transducteur 12 que l'intensité du champ $H_m$ à partir du signal de mesure V généré par le transducteur 12.

Le fonctionnement du capteur 2 va maintenant être décrit plus en détail en référence au procédé de la figure 6.

Le procédé débute par une phase 90 de calibration du capteur 2. Cette phase comprend une étape 92 lors de laquelle une première table TC1 de calibration est enregistrée dans la mémoire 24. Cette table TC1 associe à différentes valeurs prédéterminées $VT_i$ de la température du transducteur 12 une valeur $\alpha_{ti}$ de la pente de la droite qui relie la valeur de la composante $V_c$ à l'amplitude du courant $I_c$.

La phase 90 comprend également une étape 94 d'enregistrement d'une seconde table de calibration TC2. Cette table TC2 associe, à plusieurs valeurs $VT_i$ de température du transducteur 12, les coefficients correspondant de l'équation de la droite qui relie la valeur de la composante $V_m$ à l'intensité du courant $I_m$. Pour chaque valeur $VT_i$, les valeurs de ces coefficients sont respectivement notées $\alpha_{mi}$ et $\beta_{mi}$.

Les valeurs nécessaires pour construire ces tables de calibration sont par exemple obtenues expérimentalement.

Une fois le capteur 2 calibré, celui-ci est utilisé pour mesurer le courant $I_m$ inconnu qui circule dans le conducteur 4.

Pour cela, l'unité 14 exécute d'abord une phase 96 de mesure de la température $T_m$ du transducteur 12 en même temps que le courant $I_m$ inconnu circule dans le conducteur 4.

Cette phase 96 débute par une étape 98 de génération du champ $H_c$. Pour cela, la source 80 fait circuler un courant $I_c$ connu dans la ligne 82. Ici, c'est l'unité 14 qui commande la source 80 pour imposer l'amplitude du courant $I_c$. Lors de la première exécution de cette étape 98, l'amplitude du courant $I_c$ est notée $VI_{c1}$. Cette valeur $VI_{c1}$ peut être nulle. De plus, cette valeur est différente des autres valeurs que peut prendre l'intensité du courant $I_c$ lors des réitérations suivantes de cette étape 98.

Lors d'une étape 100, le transducteur 12 produit le signal de mesure V correspondant. Lors de cette étape 100, l'unité 14 de traitement acquiert le signal V.

Lors d'une étape 102, l'unité 14 de traitement extraie du signal V la valeur $VV_{c1}$ de la composante $V_c$. Différentes méthodes sont possibles pour extraire la valeur $VV_{c1}$ de la composante $V_c$ à partir des caractéristiques connues du courant $I_c$. Par exemple, ici, une démodulation synchrone ou détection synchrone est mise en oeuvre. Pour cela, le signal V est multiplié par un signal temporellement synchronisé sur le courant $I_c$. Ce signal synchronisé a par exemple exactement la même forme d'onde au même moment que le courant $I_c$. Ensuite, un filtre passe-bas est utilisé pour récupérer la composante continue. Cette composante continue permet d'obtenir la valeur $W_{c1}$ de la composante $V_c$.

Ensuite, les étapes 98 à 102 sont réitérées avec un courant $I_c$ de même fréquence mais dont l'amplitude est égale à $VI_{c2}$. La valeur $VI_{c2}$ est différente de la valeur $VI_{c1}$.

Lors d'une étape 104, l'unité 14 établit la température $T_m$ à partir des différentes valeurs $VV_{ci}$ extraites du signal V lors des itérations précédentes des étapes 98 à 102. On suppose ici que les étapes 98 à 102 ont été réitérées deux fois de manière à obtenir les valeurs $VV_{c1}$ et $VV_{c2}$ de la composante $V_c$ respectivement pour des valeurs $VI_{c1}$ et $VI_{c2}$ du courant $I_c$. A l'aide de ces valeurs $VV_{ci}$, lors d'une opération 106, l'unité 14 calcule une pente $\alpha_t$. Par exemple, la pente $\alpha_t$ est calculée à l'aide de la relation suivante :

$$\alpha_t = (VV_{c2} - VV_{c1})/(VI_{c2} - VI_{c1}).$$

Ensuite, lors d'une opération 108, l'unité 14 trouve dans la table TC1 la température $T_m$ du transducteur 12 associée à la pente $\alpha_t$ calculée lors de l'opération 106. Éventuellement, lors de cette opération 108, la valeur de la température $T_m$ est trouvée par extrapolation, par exemple linéaire, si la pente $\alpha_t$ tombe entre deux

pentes $\alpha_i$ enregistrées dans la table TC1.

La phase 96 est ici réitérée en boucles pour mesurer en permanence la température $T_m$.

En parallèle, lors d'une phase 110, l'intensité du courant $I_m$ est mesurée.

Pour cela, lors d'une étape 112, l'unité 14 établit une mesure du champ magnétique $H_m$. Ici, cette mesure correspond à la valeur de la composante $V_m$ du signal V. Cette valeur de la composante $V_m$ est par exemple extraite du signal V à l'aide de l'opération suivante : $V_m = V - V_c$, où $V_c$ est la valeur de la composante $V_c$ extraite au même moment dans le signal V.

Ensuite, lors d'une étape 114, l'unité 14 compense en température la valeur de la composante $V_m$ ainsi obtenue en fonction de la température $T_m$ mesurée au même instant lors de la phase 96. On considère que la température $T_m$ est mesurée au même instant si cette température $T_m$ est obtenue à partir du champ magnétique $H_c$ généré par la ligne 82 en même temps que le champ magnétique $H_m$ mesuré lors de cette phase 110.

Pour cela, lors d'une opération 116, l'unité 14 trouve dans la table TC2 les coefficients $\alpha_{mi}$ et $\beta_{mi}$ de la droite correspondant à la valeur de la température $T_m$ mesurée. Lors de cette opération 116, éventuellement, on utilise une extrapolation, par exemple linéaire, si la température $T_m$ tombe entre deux températures de la table TC2. La table TC2 permet donc d'obtenir la pente $\alpha_{mi}$ et la constante $\beta_{mi}$ qui définissent la droite qui relie la valeur de la composante $V_m$ à la valeur de l'intensité du courant $I_m$.

Lors d'une opération 118, l'unité 14 établit la valeur du courant $I_m$ correspondant à la composante $V_m$ en utilisant la droite dont la pente et la constante ont été trouvées lors de l'opération 116. Ainsi, la valeur du courant $I_m$ obtenue est compensée en température. L'utilisation de la droite sélectionnée en fonction de la température $T_m$ revient à utiliser une mesure du champ $H_m$ compensée en température pour établir la mesure du courant $I_m$.

La figure 7 représente un capteur 130. Ce capteur 130 est identique au capteur 2 sauf que le conducteur électrique 4 est remplacé par un conducteur électrique 132 et le dispositif 10 de mesure du champ magnétique est remplacé par un dispositif 134 de mesure d'un champ magnétique.

Le conducteur 132 comprend deux brins 136 et 138 qui s'étendent parallèlement l'un à l'autre dans la direction X. Ces brins 136 et 138 sont raccordés entre eux par un brin supplémentaire 140 de sorte que le courant $I_m$ mesuré circule dans un sens dans le brin 136 et dans le sens opposé dans le brin 138. Ici, ces brins 136, 138 et 140 forment un « U ».

Les brins 136 et 138 sont également raccordés, respectivement, à des bornes E et F d'entrée et de sortie du courant $I_m$.

Le dispositif 134 est identique au dispositif 10 sauf que la ligne conductrice 82 est omise et que le transducteur magnéto-résistif 12 est remplacé par un transducteur magnéto-résistif 144.

Dans ce mode de réalisation, la source de courant 80 est directement raccordée, respectivement, aux brins 136 et 138. Dans ces conditions, le courant $I_c$ généré par la source 80 se superpose au courant $I_m$ à mesurer dans les brins 136 et 138.

Le transducteur 144 est identique au transducteur 12 sauf que les barreaux magnéto-résistifs 30 à 33 sont remplacés, respectivement, par des barreaux magnéto-résistifs 146 à 148. Ces barreaux magnéto-résistifs 146 à 148 sont tous identiques. Par exemple, ils sont identiques aux barreaux 30. Toutefois, dans le transducteur 144, les barreaux 146 et 148 sont agencés de manière à ce que leur résistance ne varie pas en réponse à une variation de l'intensité du courant dans le conducteur 132. Par exemple, le transducteur 144 comprend un écran magnétique interposé entre les barreaux 146 et 148 et le conducteur 132.

Ici, les barreaux 146 et 147 sont disposés au-dessus du brin 136 de manière à être au moins deux ou trois plus proches de ce brin 136 que du brin 138. Ainsi, les barreaux 146 et 147 sont essentiellement sensibles au champ magnétique $H_m$ créé par le courant qui circule dans le brin 136.

De façon similaire, les barreaux 148 et 149 sont disposés au-dessus du brin 138 de manière à être deux ou trois fois plus proches de ce brin 138 que du brin 136. Ainsi, les barreaux 148 et 149 sont essentiellement sensibles au champ magnétique créé par le courant qui circule dans le brin 138.

Dans le capteur 130, le même conducteur électrique 132 est utilisé pour faire circuler les courants $I_c$ et $I_m$. Toutefois, comme précédemment, le signal de mesure généré par le transducteur 144 est formé par la somme des composantes $V_c$ et $V_m$. Le procédé de fonctionnement du capteur 130 est donc identique à celui décrit en référence à la figure 6.

De nombreux autres modes de réalisation sont possibles. Par exemple, les transducteurs magnéto-résistifs peuvent être réalisés de différentes façons. Par exemple, le transducteur magnéto-résistif est réalisé à partir d'un seul barreau magnéto-résistif. Dans ce cas, aucun pont de Wheatstone n'est utilisé.

Dans un autre mode de réalisation, une autre configuration du pont de Wheatstone que celle précédemment décrite est utilisée. Par exemple, on pourra se référer à ce sujet aux différents ponts de Wheatstone décrits dans la demande US 2011/0227560.

D'autres modes de réalisation des barreaux magnéto-résistifs sont possibles. Par exemple, le barreau magnéto-résistif est agencé pour former une jonction tunnel magnétique utilisant l'effet tunnel plus connu sous l'acronyme de TMR (Tunnel Magneto-resistance). Dans une jonction tunnel, l'espaceur est en matériau non magnétique isolant. Par exemple, il peut s'agir d'un oxyde ou d'un nitrure d'aluminium. Par exemple, l'espaceur est réalisé en alumine $Al_2O_3$, en oxyde de manganèse MgO ou en titane de strontium ($SrTiO_3$) ou autres.

Il n'est pas nécessaire que la température $T_m$ soit utilisée pour compenser une grandeur physique mesurée en même temps. En variante, la température $T_m$ utilisée pour compenser la mesure du courant $I_m$ n'est pas nécessairement établie à partir du champ magnétique $H_c$ généré en même temps que le champ $H_m$. Ainsi, si la température du transducteur magnéto-résistif ne varie pas rapidement, à l'instant $t_1$, la température du transducteur est établie. Ensuite, à un instant $t_2$ ultérieur, cette température est utilisée pour compenser la mesure du courant $I_m$.

La température établie à partir du transducteur magnéto-résistif n'est pas nécessairement utilisée pour compenser en température une grandeur physique fonction du champ $H_m$. Par exemple, la température mesurée est utilisée seulement pour estimer la température d'un moteur électrique ou autre.

Dans un autre mode de réalisation, le transducteur magnéto-résistif est uniquement utilisé pour mesurer la température en présence d'un champ magnétique inconnu sans que ce champ magnétique $H_m$ inconnu soit mesuré.

La température $T_m$ peut être utilisée pour compenser en température d'autres grandeurs physiques que le courant $I_m$. Par exemple, en variante, le champ $H_m$ est compensé en température avant l'établissement de la mesure du courant $I_m$. Pour cela, on peut procéder de façon similaire à ce qui a été décrit pour la compensation en température du courant $I_m$. Dans ce cas, de préférence, le champ $H_m$ compensé en température est utilisé pour établir la mesure du courant $I_m$. La compensation en température peut aussi avoir lieu uniquement après l'établissement du courant $I_m$, par exemple lors de l'établissement d'une valeur pour une grandeur physique fonction du courant $I_m$. Ainsi, par exemple, la température $T_m$ est utilisée pour compenser en température une puissance électrique fonction du courant $I_m$ non déjà compensé en température.

Les étapes 98, 100 et 102 peuvent être réitérées plus de deux fois pour obtenir plusieurs valeurs de la composante $V_c$. Par exemple, pour cela, l'amplitude du courant $I_c$ suit une rampe connue.

D'autres méthodes sont possibles pour extraire la valeur de la composante $V_c$ du signal V. Par exemple, un filtre passe-bande centré sur la fréquence $f_c$ du courant $I_c$ peut être utilisé.

D'autres méthodes pour établir la température à partir des valeurs de la composante $V_c$ sont possibles. Par exemple, une table de calibration codant un graphe similaire à celui de la figure 4 est enregistrée dans l'unité 14. La table enregistrée contient, pour plusieurs valeurs différentes du courant $I_c$, l'équation de la droite qui associe la valeur de la composante $V_c$ à la valeur de la température $T_m$. Ensuite, connaissant la valeur $VI_c$ du courant $I_c$, il est possible de sélectionner la droite à utiliser à l'aide de cette table de calibration. La droite sélectionnée donne la valeur de la température $T_m$ en fonction de la valeur $VV_c$ de la composante $V_c$.

**Revendications**

1. Procédé de mesure d'un premier champ magnétique et de la température d'un transducteur magnéto-résistif, l'intensité du premier champ magnétique étant inconnue, ce procédé comportant :

   - la production (100), par le transducteur magnéto-résistif, d'un signal de mesure fonction de l'intensité du premier champ magnétique, ce signal de mesure étant également fonction de la température du transducteur magnéto-résistif,
   - l'établissement (112) d'une mesure de l'intensité du premier champ magnétique à partir du signal de mesure produit, et
   - l'établissement (104) d'une mesure de la température du transducteur magnéto-résistif,

   **caractérisé en ce que** le procédé comporte également:

   - la génération (96), en même temps que le premier champ magnétique, d'un second champ magnétique, à partir d'un générateur électriquement isolé du transducteur magnéto-résistif, dont les caractéristiques sont connues, ce second champ magnétique se combinant au premier champ magnétique pour former un champ magnétique résultant qui est mesuré par le transducteur magnéto-résistif,
   - l'extraction (102), dans le signal de mesure produit, de la composante de ce signal qui est fonction uniquement du seul second champ magnétique, en utilisant les caractéristiques connues du second champ magnétique, et
   - l'établissement (104) de la température du transducteur magnéto-résistif à partir de la composante extraite.

2. Procédé selon la revendication 1, dans lequel :

   - la mesure de l'intensité du premier champ magnétique est établie (112) à partir du signal de mesure auquel a été soustraite la composante extraite, et
   - le procédé comporte la compensation (118) en température d'une grandeur physique fonction de l'intensité du premier champ magnétique, à l'aide de la température du transducteur magnéto-résistif établie à partir de la composante extraite.

3. Procédé selon la revendication 2, dans lequel la compensation (118) en température est réalisée en fonction de la température du transducteur magnéto-résistif établie à l'aide du second champ magnétique généré en même temps que le premier champ magnétique.

4. Support (24) d'enregistrement d'informations, **caractérisé en ce qu'**il comporte des instructions pour l'exécution d'un procédé de mesure conforme à l'une quelconque des revendications précédentes, lorsque ces instructions sont exécutées par un calculateur électronique.

5. Dispositif de mesure d'un premier champ magnétique et de la température d'un transducteur magnéto-résistif, l'intensité du premier champ magnétique étant inconnue, ce dispositif comportant

   - le transducteur magnéto-résistif (12 ; 144) apte à produire un signal de mesure fonction de l'intensité du premier champ magnétique, ce signal de mesure étant également fonction de la température du transducteur magnéto-résistif,
   - une unité (14) de traitement apte

     • à établir une mesure de l'intensité du premier champ magnétique à partir du signal de mesure produit, et
     • à établir une mesure de la température du transducteur magnéto-résistif, **caractérisé en ce que** :

       - le dispositif comporte également un générateur (80, 82; 80, 132), électriquement isolé du transducteur magnéto-résistif, apte à générer, en même temps que le premier champ magnétique, un second champ magnétique dont les caractéristiques sont connues, ce second champ magnétique se combinant au premier champ magnétique pour former un champ magnétique résultant qui est mesuré par le transducteur magnéto-résistif, et
       - l'unité (14) de traitement est programmée pour :

         • extraire, dans le signal de mesure produit, la composante de ce signal qui est fonction uniquement du seul second champ magnétique, en utilisant les caractéristiques connues du second champ magnétique, et
         • établir la température du transducteur magnéto-résistif à partir de la composante extraite.

6. Dispositif selon la revendication 5, dans lequel l'unité (14) de traitement est apte :

   - à générer la mesure de l'intensité du premier champ magnétique à partir du signal de mesure auquel a été soustrait la composante extraite, et
   - à compenser en température une grandeur physique fonction de l'intensité du premier champ magnétique, à l'aide de la température du transducteur magnéto-résistif établie à partir de la composante extraite.

7. Dispositif selon l'une quelconque des revendications 5 à 6, dans lequel le générateur comprend :

- une ligne conductrice (82; 132) générant le second champ magnétique lorsqu'elle est parcourue par un courant connu, et
- une source (80) de courant raccordée électriquement à la première ligne conductrice et apte à produire le courant connu dans cette ligne conductrice.

8. Dispositif selon l'une quelconque des revendications 5 à 7, dans lequel le transducteur magnéto-résistif (12; 144) comprend une vanne de spin ou une magnétorésistance tunnel.

9. Capteur de courant comportant :

- un conducteur électrique (4 ; 132) dans lequel circule le courant à mesurer,
- un dispositif (10; 134) de mesure d'un premier champ magnétique correspondant au champ magnétique généré par le courant à mesurer circulant dans le conducteur électrique,
- une unité (14) de traitement apte à établir la mesure de l'intensité du courant à mesurer à partir du premier champ magnétique mesuré par le dispositif de mesure,

caractérisé en ce que le dispositif (10 ; 134) de mesure est conforme à l'une quelconque des revendications 5 à 8.

10. Capteur selon la revendication 9, dans lequel le dispositif de mesure est conforme à la revendication 7 et la ligne conductrice (82) du générateur est électriquement isolée du conducteur électrique (4) dans lequel circule le courant à mesurer.

11. Capteur selon la revendication 9, dans lequel le dispositif de mesure est conforme à la revendication 7 et le conducteur électrique et la ligne conductrice ne forment qu'une seule ligne (134) de courant dans laquelle le courant connu de la source de courant se superpose au courant à mesurer pour générer en même temps les premier et second champs magnétiques.

**Patentansprüche**

1. Verfahren zum Messen eines ersten Magnetfeldes und der Temperatur eines magnetoresistiven Wandlers, wobei die Stärke des ersten Magnetfeldes unbekannt ist, wobei dieses Verfahren Folgendes umfasst:

- Erzeugen (100) durch den magnetoresistiven Wandler eines Messsignals, das eine Funktion der Stärke des ersten Magnetfeldes ist, wobei dieses Messsignal außerdem eine Funktion der Temperatur des magnetoresistiven Wandlers ist;
- Erstellen (112) einer Messung der Stärke des ersten Magnetfeldes anhand des erzeugten Messsignals und
- Erstellen (104) einer Messung der Temperatur des magnetoresistiven Wandlers,

**dadurch gekennzeichnet, dass** das Verfahren außerdem Folgendes umfasst:

- Erzeugen (96) gleichzeitig mit dem ersten Magnetfeld eines zweiten Magnetfeldes anhand eines von dem magnetoresistiven Wandler elektrisch isolierten Generators, dessen Eigenschaften bekannt sind, wobei dieses zweite Magnetfeld mit dem ersten Magnetfeld kombiniert wird, um ein resultierendes Magnetfeld zu erstellen, das durch den magnetoresistiven Wandler gemessen wird,
- Extrahieren (102) aus dem erzeugten Messsignal der Komponente dieses Signals, die ausschließlich eine Funktion nur des zweiten Magnetfeldes ist, indem die bekannten Eigenschaften des zweiten Magnetfeldes genutzt werden und
- Erstellen (104) der Temperatur des magnetoresistiven Wandlers anhand der extrahierten Komponente.

2. Verfahren nach Anspruch 1, wobei:

- die Messung der Stärke des ersten Magnetfeldes anhand des Messsignals, von dem die extrahierte Komponente subtrahiert wird, gebildet wird (112), und
- das Verfahren eine Temperaturkompensation (118) einer physikalischen Größe, die eine Funktion der Stärke des ersten Magnetfeldes ist, mit Hilfe der Temperatur des magnetoresistiven Wandlers, die anhand der extrahierten Komponente gebildet wird, umfasst.

3. Verfahren nach Anspruch 2, wobei die Temperaturkompensation (118) als Funktion der Temperatur des magnetoresistiven Wandlers, die mit Hilfe des zweiten Magnetfeldes gebildet wird, das gleichzeitig mit dem ersten Magnetfeld erzeugt wird, verwirklicht wird.

4. Datenaufzeichnungsträger (24), **dadurch gekenn-**

**zeichnet, dass** er Befehle für die Ausführung eines Messverfahrens nach einem der vorhergehenden Ansprüche, falls diese Befehle durch einen elektronischen Rechner abgearbeitet werden, umfasst.

5. Vorrichtung zum Messen eines ersten Magnetfeldes und der Temperatur eines magnetoresistiven Wandlers, wobei die Stärke des ersten Magnetfeldes unbekannt ist, wobei diese Vorrichtung Folgendes umfasst:

- den magnetoresistiven Wandler (12; 144), der ein Messsignal erzeugen kann, das eine Funktion der Stärke des ersten Magnetfeldes ist, wobei dieses Messsignal außerdem eine Funktion der Temperatur des magnetoresistiven Wandlers ist,
- eine Verarbeitungseinheit (14), die

• eine Messung der Stärke des ersten Magnetfeldes anhand des erzeugten Messsignals erstellen kann und
• eine Messung der Temperatur des magnetoresistiven Wandlers erstellen kann, **dadurch gekennzeichnet, dass**:

- die Vorrichtung außerdem einen Generator (80, 82; 80, 132) umfasst, der von dem magnetoresistiven Wandler elektrisch isoliert ist und gleichzeitig mit dem ersten Magnetfeld ein zweites Magnetfeld erzeugen kann, dessen Eigenschaften bekannt sind, wobei das zweite Magnetfeld mit dem ersten Magnetfeld kombiniert wird, um ein resultierendes Magnetfeld zu erstellen, das durch den magnetoresistiven Wandler gemessen wird, und
- die Verarbeitungseinheit (14) programmiert ist, um:

• aus dem erzeugten Messsignal die Komponente dieses Signals zu extrahieren, die nur eine Funktion nur des zweiten Magnetfeldes ist, indem die bekannten Eigenschaften des zweiten Magnetfeldes genutzt werden, und
• die Temperatur des magnetoresistiven Wandlers anhand der extrahierten Komponente zu erstellen.

6. Vorrichtung nach Anspruch 5, wobei die Verarbeitungseinheit (14):

- die Messung der Stärke des ersten Magnetfeldes anhand des Messsignals, von dem die extrahierte Komponente subtrahiert wird, erzeugen kann und

- eine Temperaturkompensation einer physikalischen Größe, die eine Funktion der Stärke des ersten Magnetfeldes ist, mit Hilfe der Temperatur des magnetoresistiven Wandlers, die anhand der extrahierten Komponente gebildet wird, ausführen kann.

7. Vorrichtung nach einem der Ansprüche 5 bis 6, wobei der Generator Folgendes umfasst:

- eine elektrische Leitung (82; 132), die das zweite Magnetfeld erzeugt, wenn sie von einem bekannten Strom durchflossen wird, und
- eine Stromquelle (80), die mit der ersten elektrischen Leitung elektrisch verbunden ist und den bekannten Strom in dieser elektrischen Leitung erzeugen kann.

8. Vorrichtung nach einem der Ansprüche 5 bis 7, wobei der magnetoresistive Wandler (12; 144) ein Spin-Ventil oder einen Magnetowiderstandstunnel enthält.

9. Stromsensor, der Folgendes umfasst:

- einen elektrischen Leiter (4; 132), in dem ein zu messender Strom fließt,
- eine Vorrichtung (10; 134) zum Messen eines ersten Magnetfeldes, das dem Magnetfeld entspricht, der durch den zu messenden Strom erzeugt wird, der in dem elektrischen Leiter fließt,
- eine Verarbeitungseinheit (14), die die Messung der Stärke des zu messenden Stroms anhand des durch die Messvorrichtung gemessenen ersten Magnetfeldes erstellen kann, und

**dadurch gekennzeichnet, dass** die Messvorrichtung (10; 134) wie in einem der Ansprüche 5 bis 8 beschaffen ist.

10. Sensor nach Anspruch 9, wobei die Messvorrichtung wie in Anspruch 7 beschaffen ist und die elektrische Leitung (82) des Generators von dem elektrischen Leiter (4), in dem der zu messende Strom fließt, elektrisch isoliert ist.

11. Sensor nach Anspruch 9, wobei die Messvorrichtung wie in Anspruch 7 beschaffen ist und der elektrische Leiter und die elektrische Leitung nur eine einzige Stromleitung (134) bilden, in der der bekannte Strom der Stromquelle dem zu messenden Strom überlagert ist, um gleichzeitig das erste und das zweite Magnetfeld zu erzeugen.

**Claims**

1. Method for measuring a first magnetic field and the temperature of a magneto-resistive transducer, the intensity of the first magnetic field being unknown, this method comprising:

- the production (100), by the magneto-resistive transducer, of a measurement signal dependent on the intensity of the first magnetic field, this measurement signal also being dependent on the temperature of the magneto-resistive transducer,
- the establishment (112) of a measurement of the intensity of the first magnetic field on the basis of the measurement signal produced, and
- the establishment (104) of a measurement of the temperature of the magneto-resistive transducer, **characterized in that** the method also comprises:

- the generation (96), at the same time as the first magnetic field, of a second magnetic field, on the basis of a generator electrically insulated from the magneto-resistive transducer, whose characteristics are known, this second magnetic field being combined with the first magnetic field to form a resultant magnetic field which is measured by the magneto-resistive transducer,
- the extraction (102), from the measurement signal produced, of the component of this signal which is dependent solely on the second magnetic field alone, using the known characteristics of the second magnetic field, and
- the establishment (104) of the temperature of the magneto-resistive transducer on the basis of the component extracted.

2. Method according to Claim 1, in which:

- the measurement of the intensity of the first magnetic field is established (112) on the basis of the measurement signal from which the extracted component has been subtracted, and
- the method comprises the temperature compensation (118) of a physical quantity dependent on the intensity of the first magnetic field, with the aid of the temperature of the magneto-resistive transducer established on the basis of the component extracted.

3. Method according to Claim 2, in which the temperature compensation (118) is carried out as a function of the temperature of the magneto-resistive transducer established with the aid of the second magnetic field generated at the same time as the first magnetic field.

4. Information recording medium (24), **characterized in that** it comprises instructions for the execution of a measurement method in accordance with any one of the preceding claims, when these instructions are executed by an electronic computer.

5. Device for measuring a first magnetic field and the temperature of a magneto-resistive transducer, the intensity of the first magnetic field being unknown, this device comprising

- the magneto-resistive transducer (12; 144) able to produce a measurement signal dependent on the intensity of the first magnetic field, this measurement signal also being dependent on the temperature of the magneto-resistive transducer,
- a processing unit (14) able

• to establish a measurement of the intensity of the first magnetic field on the basis of the measurement signal produced, and
• to establish a measurement of the temperature of the magneto-resistive transducer,

**characterized in that**:

- the device also comprises a generator (80, 82; 80, 132), electrically insulated from the magneto-resistive transducer, able to generate, at the same time as the first magnetic field, a second magnetic field whose characteristics are known, this second magnetic field being combined with the first magnetic field to form a resultant magnetic field which is measured by the magneto-resistive transducer, and
- the processing unit (14) is programmed to:

• extract, from the measurement signal produced, the component of this signal which is dependent solely on the second magnetic field alone, using the known characteristics of the second magnetic field, and
• establish the temperature of the magneto-resistive transducer on the basis of the component extracted.

6. Device according to Claim 5, in which the processing unit (14) is able:

- to generate the measurement of the intensity of the first magnetic field on the basis of the measurement signal from which the extracted component has been subtracted, and
- to temperature-compensate a physical quantity dependent on the intensity of the first magnetic field, with the aid of the temperature of the magneto-resistive transducer established on the basis of the component extracted.

7. Device according to either of Claims 5 and 6, in which the generator comprises:

- a conducting line (82; 132) generating the second magnetic field when it is traversed by a known current, and
- a current source (80) connected electrically to the first conducting line and able to produce the known current in this conducting line.

8. Device according to any one of Claims 5 to 7, in which the magneto-resistive transducer (12; 144) comprises a spin valve or a tunnel magnetoresistor.

9. Current sensor comprising:

- an electrical conductor (4; 132) in which the current to be measured flows,
- a measurement device (10; 134) for measuring a first magnetic field corresponding to the magnetic field generated by the current to be measured flowing in the electrical conductor,
- a processing unit (14) able to establish the measurement of the intensity of the current to be measured on the basis of the first magnetic field measured by the measurement device,

**characterized in that** the measurement device (10; 134) is in accordance with any one of Claims 5 to 8.

10. Sensor according to Claim 9, in which the measurement device is in accordance with Claim 7 and the conducting line (82) of the generator is electrically insulated from the electrical conductor (4) in which the current to be measured flows.

11. Sensor according to Claim 9, in which the measurement device is in accordance with Claim 7 and the electrical conductor and the conducting line form just a single current line (134) in which the known current of the current source is superimposed with the current to be measured so as to generate the first and second magnetic fields at the same time.

Fig. 1

Fig. 2

Fig. 3

Fig. 4

Fig. 5

Fig. 6

Fig. 7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050077890 A
- US 2010231213 A1

- US 20110227560 A

**Littérature non-brevet citée dans la description**

- Novel zero-drift détection method for highly sensitive GMR biochips. **HAN et al.** IEEE Transactions on magnetics. IEEE Service center, 01 Octobre 2006, vol. 42